(19) Europäisches Patentamt
European Patent Office
Office européen des brevets

(11) **EP 1 507 895 B1**

(12) **EUROPÄISCHE PATENTSCHRIFT**

(45) Veröffentlichungstag und Bekanntmachung des Hinweises auf die Patenterteilung:
**21.07.2010 Patentblatt 2010/29**

(21) Anmeldenummer: **03755134.8**

(22) Anmeldetag: **26.05.2003**

(51) Int Cl.:
*C23C 16/54* (2006.01)   *C23C 16/04* (2006.01)

(86) Internationale Anmeldenummer:
**PCT/EP2003/005499**

(87) Internationale Veröffentlichungsnummer:
**WO 2003/100129 (04.12.2003 Gazette 2003/49)**

(54) **RUNDLÄUFERMASCHINE FÜR CVD-BESCHICHTUNGEN**

ROTARY MACHINE FOR CVD COATINGS

MACHINE TOURNANTE POUR APPLICATION DE REVETEMENTS PAR DEPOT CHIMIQUE EN PHASE VAPEUR

(84) Benannte Vertragsstaaten:
**AT BE BG CH CY CZ DE DK EE ES FI FR GB GR HU IE IT LI LU MC NL PT RO SE SI SK TR**

(30) Priorität: **24.05.2002 DE 10223288**
**01.06.2002 DE 10224395**
**07.06.2002 DE 10225607**
**11.06.2002 DE 10225985**
**16.11.2002 DE 10253512**
**16.11.2002 DE 10253513**

(43) Veröffentlichungstag der Anmeldung:
**23.02.2005 Patentblatt 2005/08**

(73) Patentinhaber: **Schott AG**
**55122 Mainz (DE)**

(72) Erfinder:
• **BEHLE, Stephan**
**55239 Gau-Odernheim (DE)**
• **LÜTTRINGHAUS-HENKEL, Andreas**
**64289 Darmstadt (DE)**
• **ARNOLD, Gregor**
**55294 Bodenheim (DE)**
• **BICKER, Matthias**
**55126 Mainz (DE)**
• **KLEIN, Jürgen**
**55127 Mainz (DE)**

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
**WO-A-99/17334      DE-A- 19 916 478**
**FR-A- 2 791 598      GB-A- 547 249**
**US-A- 2 730 987**

• **DATABASE WPI Week 200111, Derwent Publications Ltd., London, GB; Class L03, AN 2001-095118 & JP 2000 294548 A (CANON) 20 Oktober 2000**

**EP 1 507 895 B1**

**Beschreibung**

Die Erfindung betrifft eine Rundläufermaschine und ein Verfahren zur Behandlung von Werkstücken, insbesondere eine Rundläufermaschine und ein Verfahren für CVD-Beschichtungen mit rotierenden Pumpeinrichtungen.

Die beispielsweise zur Aufbewahrung von Lebensmitteln immer häufiger verwendeten Kunststoffbehälter weisen im allgemeinen eine vergleichsweise hohe Permeation für Gase auf. So entweicht mit der Zeit Kohlensäure aus kohlensäurehaltigen Getränken, die in solchen Behältern aufbewahrt werden, wodurch die Getränke schnell schal werden. Außerdem kann auch Sauerstoff durch den Kunststoff dringen und Oxidationsprozesse in darin aufbewahrten Lebensmitteln in Gang setzen, was ebenfalls deren Haltbarkeit deutlich verkürzt. Andererseits weisen Kunststoffbehälter auch vielseitige Vorzüge, wie etwa niedriges Gewicht, niedriger Stückpreis und Stabilität gegenüber mechanischen Beanspruchungen aufgrund der gegenüber Glasbehältern hohen Elastizität.

Um diese Vorzüge von Kunststoffbehältern mit denen von Glasbehältern mit ihrer äußerst guten Barrierewirkung zu vereinen, ist es bekannt, Kunststoffbehälter mit Barrierebeschichtungen, beziehungsweise Diffusionssperrschichten zu versehen, welche die Barrierewirkung von solchen Behältern um Größenordnungen verbessern.

Derartige Beschichtungen können sogar auf Glasbehältern, beispielsweise im Bereich der Pharmaverpackungen sinnvoll sein, wobei etwa die Migration von Alkaliionen aus der Glasbehälter-Wandung in den Innenraum durch eine Siliziumoxid-Barriere verhindert werden kann.

Eine besonders effektive und kostengünstige Technologie für das Aufbringen solcher Schichten ist die chemische Dampfphasenabscheidung (CVD). Bei den CVD-Verfahren geschieht die Abscheidung einer Schicht über ein reaktives chemisches Gasgemisch, welche die zu beschichtende Oberfläche umgibt. Aus Gemischen verschiedener Gase läßt sich so eine nahezu unbegrenzte Vielfalt möglicher Schichten erzeugen. Als Diffusionsbarrieren haben sich dabei unter anderem Oxidschichten, wie etwa die bereits erwähnten $SiO_2$-Schichten bewährt.

Ein chemisch reaktives Gasgemisch kann für die CVD-Beschichtung thermisch oder durch Ionisation der Prozeßgase zum Beispiel durch Eintrag von elektromagnetischer Energie erzeugt werden. Da Kunststoffe in der Regel thermisch nicht ausreichend stabil sind oder niedrige Erweichungspunkte aufweisen, ist für die Beschichtung von Kunstoffoberflächen CVD-Beschichtung unter Temperatureinwirkung ungeeignet. Hier bietet sich jedoch die Möglichkeit der Plasmaunterstützten CVD-Beschichtung (PECVD) an. Da auch hier durch das Plasma eine Erwärmung der zu beschichtenden Oberfläche auftritt ist insbesondere auch die Plasmaimpuls-CVD-Beschichtung (PICVD) geeignet.

Um ein solches Verfahren industriell einsetzen zu können, werden aufgrund der Prozeßzeiten eine Vielzahl von Kammern benötigt, in denen gleichzeitig oder zeitlich versetzt eine Beschichtung durchgeführt wird. Da PICVD-Beschichtungen unter Niederdruckbedingungen durchgeführt werden, ergibt sich dabei das Problem, die zu beschichtenden Werkstücke, wie etwa Kunststoffhohlkörper in die Beschichtungsbereiche zu schleusen und diese sehr schnell zu evakuieren, da insbesondere bei der Beschichtung von Massenartikeln hohe Durchsätze durch eine Beschichtungsvorrichtung erreicht werden müssen und so nur wenig Zeit für die Evakuierung zur Verfügung steht.

Um die geforderten hohen Durchsätze erreichen zu können, ist eine Rundläufervorrichtung vorteilhaft, bei welcher die Beschichtungsstationen für die zu beschichtenden Werkstücke auf einer kreisförmigen Bahn umlaufen. Mit derartigen Vorrichtungen kann ein kontinuierlicher Beschichtungsablauf realisiert werden, bei der die einzelnen Bearbeitungsphasen während des Umlaufs bestimmten Kreissegmenten oder Winkelbereichen zugeordnet sind.

Eine solche Vorrichtung ist unter anderem aus der DE 199 16 478 A1 und der WO 00 58631 bekannt.

Das in der DE 199 16 478 A1 vorgeschlagene Verfahren ermöglicht die Evakuierung von Reaktoren zur Plasmasterilisation. Erfindungsgemäß müssen die an einem Rundläufer angeordneten Reaktoren bis auf den Plasma-Entladungsdruck evakuiert werden, wobei die Evakuierung mittels parallel geschalteter Pumpen, die über Ringverteiler mit den Reaktoren verbunden sind, vorgenommen wird. Die Evakuierung verläuft dabei in Stufen, wobei die einzelnen Stufen unterschiedlichen Pumpen oder Pumpsystemen zugeordnet sind. Mit jedem Pumpvorgang können mehrere Reaktoren gleichzeitig evakuiert werden.

Bei dem in der Druckschrift WO 00 58631 vorgeschlagenen Förderkarussell für die Plasmabehandlung von dielektrischen Hohlkörpern mit mehreren identischen Behandlungsstationen, die jeweils für die Aufnahme von mindestens einem Hohlkörper ausgelegt sind, werden die Behandlungsstationen zur Evakuierung mittels Verteilereinrichtungen mit rotierenden luftdichten Anschlüssen mit Druckquellen in Verbindung gebracht. Dabei weist das Förderkarussell mindestens zwei unabhängige und gleichwertige Druckquellen auf. Die Behandlungsstationen sind in Gruppen unterteilt, die jeweils einer Druckquelle zugeteilt sind. Zu- und Abschaltung zu den Druckquellen erfolgt dabei über die Verteilereinrichtung mit dem rotierenden Anschlüssen.

Dieses Förderkarussell weist jedoch mehrere Nachteile auf. Es hat sich unter anderem als günstig erwiesen, die Beschichtungsstationen nicht mit einer einzelnen Pumpvorrichtung abzupumpen. Um schnell niedrige Drücke zu erreichen, ist vielmehr ein mehrstufiges Abpumpen auf unterschiedlichen Druckstufen günstig, während die in WO 00 58631 offenbarte Vorrichtung nur eine Verbindung einer Behandlungsstation mit jeweils einer Druckquelle vorsieht.

Weiterhin muß eine drehende Verbindung zwischen den Druckquellen und den sich drehenden Behandlungsstationen realisiert werden. Bei niedrigen Drücken sind hier die Anforderungen an die Dichtigkeit und den Leitwert sehr hoch, was mit einer erhöhten Anfälligkeit der Vorrichtung einhergeht.

Darüber hinaus bedingt eine Verteilereinrichtung mit rotierenden, luftdichten Anschlüssen eine Anordnung dieser Einrichtung an der Drehachse des Förderkarussells, während die Beschichtungsstationen am Umfang des Karussells angebracht sind. Dadurch werden lange Vakuumverbindungsleitungen von der Verteilereinrichtung zu den Behandlungsstationen erforderlich. Dies ist jedoch für den Leitwert des Vakuumsystems abträglich und wirkt sich damit nachteilig auf die Dauer der notwendigen Evakuierungszeit aus.

Auch kann ein gemeinsamer Anschluß zweier zu einer Gruppe gehörenden Behandlungsstationen an einer gemeinsamen Druckquelle zu einem Übersprechen der über die Druckquelle miteinander verbundenen Behandlungsstationen führen, wenn sich diese auf unterschiedlichen Druckniveaus befinden.

Der Erfindung liegt daher die Aufgabe zugrunde, eine Rundläufermaschine und ein Verfahren für CVD-Beschichtungen anzugeben, welche eine besonders effektive und schnelle Beschichtung von Werkstücken ermöglicht.

Diese Aufgabe wird bereits in höchst überraschend einfacher Weise mit einer Rundläufervorrichtung oder Plasmamodul zur Behandlung, insbesondere für CVD- oder Plasmabeschichtungen von Werkstücken gemäß Anspruch 1, sowie ein Verfahren gemäß Anspruch 22 gelöst. Vorteilhafte Weiterbildungen der Vorrichtung sind in den Unteransprüchen angegeben.

Dementsprechend umfaßt eine erfindungsgemäße Rundläufervorrichtung

- ein Förderkarussell oder Plasmarad,
- Behandlungs- oder Plasmastationen, welche mit dem Förderkarussell transportiert werden, und
- zumindest eine erste Pumpeinrichtung oder Fördereinrichtung für ein Betriebsmittel. Dabei wird die erste Pumpeinrichtung mit dem Förderkarussells transportiert.

Dadurch, daß die Pumpeinrichtung mit dem Förderkarussell transportiert wird, kann bei der Verbindung dieser Pumpeinrichtung mit den Behandlungsstationen auf eine vakuumdichte Drehzuführung verzichtet werden. Auch die Zuleitungen können durch eine sonst bei Verwendung einer Drehzuführung nicht realisierbare Nähe der Pumpeinrichtung zu den Behandlungsstationen kurz gehalten und mit großen Querschnitten vorgesehen werden.

Bei rotierenden Anschlüssen wachsen demgegenüber auch die Schwierigkeiten, die Verbindung dicht zu halten, mit dem Durchmesser und damit mit dem erreichbaren Leitwert.

Das erfindungsgemäße Verfahren zur CVD-Beschichtung von Werkstücken in einer insbesondere wie oben beschriebenen Rundläüfervorrichtung, sieht dementsprechend vor, daß

- wenigstens ein Werkstück in eine Behandlungsstation auf einem rotierenden Förderkarussell eingeführt,
- die Behandlungsstation mit zumindest einer ersten Pumpeinrichtung verbunden,
- die Behandlungsstation evakuiert, und
- das Werkstück beschichtet wird,

wobei die erste Pumpeinrichtung mit dem Förderkarussel befördert wird.

Nach erfolgter Beschichtung können dann die Behandlungsstationen belüftet und die Werkstücke herausgenommen werden.

Die Verbindung der einen oder mehreren Pumpeinrichtungen mit den Behandlungsstationen kann vorteilhaft mittels einer Verteilereinrichtung hergestellt werden. Diese kann mit Vorteil einen Verteiler, insbesondere in Form eines Ringverteilers umfassen, an dem die Pumpeinrichtungen und Verbindungsleitungen zu den Beschichtungskammern angeschlossen sind.

Die Verbindung einer bestimmten Behandlungsstation mit einer Pumpeinrichtung kann dabei durch die Verteilereinrichtung in Abhängigkeit von der Winkelposition der Behandlungsstation auf dem Förderkarussell geschehen. Dazu kann die Verteilereinrichtung Steuerventile umfassen. Das Verbinden der Behandlungsstationen mit der ersten oder zweiten Pumpeinrichtung kann so durch Schalten der Steuerventile erfolgen, wobei die Ventile an entsprechenden Winkelpositionen geöffnet oder geschlossen werden und so die Verbindung mit der Pumpeinrichtung oder dem Verteiler herstellen.

Besonders bevorzugt weist die erfindungsgemäße Rundläufervorrichtung außerdem zumindest eine feststehend angeordnete zweite Pumpeinrichtung oder externe Fördereinrichtung auf. Die Behandlungsstationen können dabei zur Evakuierung auch mit dieser zweiten Pumpeinrichtung verbunden werden. Dazu kann die zweite, feststehende Pumpeinrichtung ebenso wie die erste, mitrotierende Pumpeinrichtung mit wenigstens einer, insbesondere auch derselben Verteilereinrichtung zur Verbindung der Behandlungsstationen mit der zweiten Pumpeinrichtung verbunden sein.

Das Evakuieren der Behandlungsstationen erfolgt bevorzugt in wenigstens zwei Schritten oder Evakuierungsphasen, wobei zwischen den Schritten bevorzugt zwischen verschiedenen Pumpeinrichtungen umgeschaltet wird. Um den Enddruck schnell erreichen zu können, ist es beispielsweise von Vorteil, wenn die erste und zweite Pumpeinrichtung für unterschiedliche Druckbereiche angepaßt sind. Diese können dann beispielsweise während der Evakuierung nacheinander nach absteigenden Druckbereichen geordnet mit den Behandlungsstationen verbunden werden, so daß jede Pumpeinrichtung in dem für sie optimalen Druckbereich arbeitet. Insbesondere ist es dabei von Vorteil, wenn die mitrotierende erste Pumpeinrichtung für einen niedrigeren Druckbereich optimiert ist, als die zweite Pumpeinrichtung, da bei sinkendem Druck bei gleichbleibendem Saugvermögen die Saugleistung abnimmt. Dementsprechend sind für kurze Abpumpzeiten besonders bei niedrigen Drücken gute Leitwerte der Zuleitungen wichtig um ein möglichst großes effektives Saugvermögen zu erhalten.

Außerdem ist es aber auch möglich, neben einer Umschaltung zwischen Pumpeinrichtungen auch eine Hinzuschaltung von Pumpeinrichtungen vorzunehmen um die Saugleistung dem in der Beschichtungskammer herrschenden Druck anzupassen.

Besonders vorteilhaft wird das Evakuieren sowohl bei einstufigem Abpumpen, als auch bei Evakuierung in mehreren Schritten so vorgenommen, daß eine Pumpeinrichtung nur mit jeweils einer Behandlungsstation verbunden ist. Dies ist vorteilhaft, da auf diese Weise vermieden wird, daß eine Pumpeinrichtung mit zwei Behandlungsstationen verbunden ist, deren Beschichtungskammern unterschiedliche Drücke aufweisen. Ansonsten würde dies zu einer Einstellung eines mittleren Druckes in beiden Behandlungsstationen durch einen Gasfluß über die Pumpeinrichtung und damit zu einem Druckanstieg in der Kammer mit anfangs niedrigerem Druck führen.

Insbesondere bei Rundläufervorrichtungen mit hoher Stückleistung kann es auch von Vorteil sein, mehr als nur eine einzelne Pumpeinrichtung für einen Evakuierungsschritt, beziehungsweise eine Evakuierungsphase vorzusehen. Die Pumpleistung kann daher gemäß einer weiteren Ausführungsform der Erfindung dadurch gesteigert werden, indem die Rundläufervorrichtung zumindest zwei gleichartige oder gleichwertige Pumpeinrichtungen umfaßt. Diese gleichartigen oder gleichwertigen Pumpeinrichtungen können mitrotierende erste und/oder feststehende zweite Pumpeinrichtungen sein. Das Evakuieren der Behandlungsstationen erfolgt dann gemäß dieser Ausführungsform der Erfindung mit den gleichartigen oder gleichwertigen Pumpeinrichtungen während zumindest einer Evakuierungsphase.

Gemäß einer vorteilhaften Weiterbildung dieser Ausführungsform der Erfindung wird jeweils eine der gleichartigen oder gleichwertigen Pumpeinrichtungen mit zumindest einer Behandlungsstation für die Dauer der wenigstens einen Evakuierungsphase verbunden. Dazu ist eine Verteilereinrichtung zur Verbindung der Behandlungsstationen mit den Pumpeinrichtungen vorgesehen, welche jeweils eine der gleichartigen oder gleichwertigen Pumpeinrichtungen mit zumindest einer Behandlungsstation für die Dauer der Evakuierungsphase verbindet.

Dabei wird beispielsweise eine Behandlungsstation oder eine Gruppe von Behandlungsstationen beim Eintritt in ein einer Evakuierungsphase zugeordnetes Kreissegment mit einer ersten der gleichartigen Pumeinrichtungen verbunden. Die nächste Behandlungsstation oder Gruppe von Behandlungsstation wird beim Eintritt in das Kreissegment dann mit der zweiten der gleichartigen Pumpeinrichtungen verbunden. Diese Abfolge der Verbindung mit den Pumpeinrichtungen kann dann vorteilhaft zyklisch fortgesetzt werden.

Durch die erfindungsgemäße, mitrotierende Anordnung der ersten Pumpeinrichtung in der Rundläufervorrichtung können kurze Verbindungsleitungen der Pumpeinrichtung oder den Pumpeinrichtungen zu den Beschichtungsstationen mit großen Leitungsquerschnitten realisiert werden. Auf diese Weise ist es möglich, daß das effektive Saugvermögen der ersten Pumpeinrichtung gegenüber dem tatsächlichen maximalen Saugvermögen der Pumpeinrichtung nur verhältnismäßig wenig reduziert wird. Dabei besteht zwischen tatsächlichem Saugvermögen $S$ und effektivem, durch die Zuleitung reduziertem Saugvermögem $S_{eff}$ der Zusammenhang:

$$(1) \quad \frac{1}{S_{eff}} = \frac{1}{S} + \frac{1}{L},$$

wobei $L$ den Leitwert oder Strömungsleitwert der Zuleitung bezeichnet.

Der Strömungsleitwert wird wesentlich durch den Querschnitt der Rohrleitungen bestimmt und ist beispielsweise der für eine Leitung gegeben durch die Beziehung:

$$(2) \quad L = \frac{q_{pv}}{p_0 - p_2}.$$

Dabei bezeichnet $p_0$ den Druck vor der Leitung und $p_2$ den Druck am pumpenseitigen Ende der Leitung. Mit $q_{pv}$ ist der p·V-Strom durch die Vakuumleitung bezeichnet. Dieser ist beispielsweise für den Fall laminarer Strömung gegeben durch (siehe beispielsweise "Handbuch Vakuumtechnik", 6. Auflage, Vieweg-Verlag 1997):

$$(3) \quad q_{pv} = \frac{\pi}{128\eta} \cdot \frac{d^4}{l} \cdot \frac{p_0}{}$$

Mit $\eta$ ist dabei die dynamische Viskosität des Gases bezeichnet. Die Größen d und 1 bezeichnen den Durchmesser und die Länge der Leitung. Anhand von Gleichung 3 wird ersichtlich, daß der Leitwert der Vakuumleitungen in starkem Maße von deren Länge und insbesondere deren Durchmesser abhängt. Ferner wird aus Gleichung (2) in Verbindung mit Gleichung (3) auch ersichtlich, daß der Leitwert bei sinkenden Druckdifferenzen abnimmt. Bei sinkenden Drücken werden auch dementsprechend die auftretenden Druckdifferenzen kleiner. Somit ist der Leitungsquerschnitt oder der Koeffizient von Durchmesser zu Länge, d/l, bei höheren Drücken weniger kritisch für den Leitwert als dies bei niedrigeren Druckbereichen der Fall ist. Durch die erfindungsgemäße Anordnung der ersten Pumpeinrichtung auf dem Förderkarussel und die damit mögliche Realisierung besonders kurzer Vakuumleitungen von dieser Pumpeinrichtung zu den Behandlungsstationen kann so das Evakuieren deutlich beschleunigt werden. Gemäß einer Ausführungsform der Erfindung kann so beispielsweise der Quotient d/l aus Durchmesser d der Vakuumleitung zwischen erster Pumpeinrichtung und einer Verteilereinrichtung zu deren Länge 1 größer oder gleich 1/15, bevorzugt größer oder gleich 1/10 betragen.

Bei einer Ausführungsform der Erfindung mit zumindest einer zweiten, feststehenden Pumpeinrichtung kann diese als Vorstufe zu der ersten, mitrotierenden Pumpeinrichtung und/oder als erste Pumpstufe bei der Evakuierung einer Behandlungsstation verwendet werden. In beiden Fällen arbeitet dann die zweite, feststehende Pumpeinrichtung in einem höheren Druckbereich als die erste, mitrotierende Pumpeinrichtung. Dementsprechend erhöht sich gemäß den Gleichungen (2) und (3) bei gegebenem Leitungsquerschnitt der Leitwert, so daß die Vakuumverbindung von der feststehenden zweiten Pumpeinrichtung zum rotierenden Förderkarussell und die Länge der Vakuumleitungen hier weniger kritisch ist. Gemäß einer Ausführungsform der erfindungsgemäßen Vorrichtung kann dabei beispielsweise die zweite Pumpeinrichtung so angeordnet und eine Vakuumleitung von der Pumpeinrichtung zu einer Verteilereinrichtung wie insbesondere einem Ringverteiler oder zu einer ersten Pumpeinrichtung so dimensioniert werden, daß der Quotient d/l aus Durchmesser d der Vakuumleitung zwischen zweiter Pumpeinrichtung und einer Verteilereinrichtung zu deren Länge 1 größer oder gleich 1/60, bevorzugt größer oder gleich 1/30 beträgt.

Gemäß einer Ausführungsform des erfindungsgemäßen Verfahrens erfolgt die Evakuierung der Behandlungsstationen in vier Evakuierungssschritten. Eine gute Abstufung wird dabei erreicht, wenn die Pumpeinrichtungen so umgeschaltet werden, daß der Druck in einer Behandlungsstation stufenweise in einem ersten Schritt bis auf $\leq 200$ mbar, in einem darauffolgenden zweiten Schritt bis auf $\leq 80$ mbar,' in einem darauffolgenden dritten Schritt bis auf $\leq 1,5$ mbar, in einem darauffolgenden vierten Schritt bis auf $\leq 0,1$ mbar reduziert wird.

Eine weitere Ausführungsform der Erfindung sieht ferner eine Evakuierung in fünf Schritten vor. Dabei kann beispielsweise die Evakuierung wie bei dem oben angegebenen vierschrittigen Verfahren erfolgen und in einem darauffolgenden fünften Schritt dann der Druck in der Behandlungsstation bis auf $\leq 0,01$ mbar reduziert werden. Bei beiden Ausführungsformen kann dann zum Beispiel in einem weiteren Schritt auf eine Pumpeinrichtung zur Absaugung des Prozeßgases umgeschaltet werden.

Als Vakuumquellen für die Pumpeinrichtung sind dabei unter anderem Wälzkolbenpumpen geeignet. Diese zeichnen sich durch ein hohes Saugvermögen bei niedrigen Drücken, insbesondere im Feinvakuumbereich aus.

Alternativ oder zusätzlich kann die zweite Pumpeinrichtung auch als Vorstufe der ersten Pumpeinrichtung betrieben, beziehungsweise an diese angeschlossen werden. Dadurch wird ein Vorvakuum für die erste Pumpeinrichtung bereitgestellt, wodurch sich deren Saugleistung bei niedrigen Drücken erhöht. Die zweite Pumpeinrichtung kann beispielsweise eine oder mehrere Drehschieberpumpen umfassen. Dieser Pumpentyp ist gekennzeichnet durch hohe Saugleistungen bei höheren Drücken im Grobvakuumbereich.

Die feststehende zweite Pumpeinrichtung kann zum Beispiel mittels einer Drehzuführung oder Drehkupplung mit dem Förderkarussell verbunden werden. Ist die zweite Pumpeinrichtung für einen höheren Druckbereich vorgesehen, so sind hier die Anforderungen bezüglich Leitwert und Leckrate der Drehzuführung erheblich niedriger, als wenn über eine solche Verbindung der Enddruck hergestellt werden müßte. Gemäß einer Ausführungsform ist dabei die Leckrate der Drehzuführung $10^{-1}$ mbar 1/sec oder kleiner, bevorzugt im Bereich zwischen $10^{-2}$ bis $10^{-4}$ mbar 1/sec bei ruhendem und/oder drehendem Betrieb.

Es hat sich als günstig erwiesen, wenn auch das Abpumpen mit den ersten und/oder zweiten Pumpeinrichtungen jeweils in mehreren Stufen bei unterschiedlichen Druckbereichen durchgeführt wird. Gegenüber einer einstufigen Evakuierung kann dabei die gesamte Pumpleistung und damit die Größe der verwendeten Pumpen deutlich reduziert werden. Dementsprechend können vorteilhaft zumindest zwei feststehende erste und/oder zweite Pumpeinrichtungen vorgesehen sein, welche bei Drehung des Förderkarussells nacheinander mit den Behandlungsstationen verbunden werden.

Um weiterhin bei niedrigen Drücken in der Beschichtungskammer eine große Saugleistung bereitstellen zu können, ist es außerdem von Vorteil, wenn eine erste Pumpeinrichtung zumindest zwei hintereinandergeschaltete Pumpstufen umfaßt. Auch können während der Evakuierungsphase, etwa durch geeignete Schaltung der Steuerventile zeitweise zwei oder mehr erste Pumpeinrichtungen hintereinandergeschaltet werden.

Besonders bevorzugt wird die erfindungsgemäße Rundläufervorrichtung für die PECVD- oder PICVD-Beschichtung eingesetzt, wobei das Werkstück durch Zuführen von Prozeßgas und elektromagnetischer Energie in die Behandlungsstation beschichtet wird. Dazu weist die Vorrichtung außerdem eine Einrichtung zur Zuführung von Prozeßgas in die Behandlungsstationen, sowie eine Einrichtung zur Zuführung von elektromagnetischer Energie, vorzugsweise von Mikrowellen auf. Mittels der Mikrowellen wird in der Prozeßgasatmosphäre dann ein Plasma erzeugt, dessen Reaktionsprodukte sich auf Oberfläche der zu beschichtenden Werkstücke abscheiden. Insbesondere kann dabei auch eine Innenbeschichtung von hohlkörperförmigen Werkstücke, wie etwa Ampullen oder Flaschen aus Kunststoff oder Glas vorgenommen werden, indem im Innenbereich der Werkstücke ein Plasma gezündet wird. Dazu wird Prozeßgas in den Innenbereich der Werkstücke eingefüllt.

Sollen nur die Innenseiten solcher Werkstücke beschichtet werden, so können die Werkstücke in entsprechenden Aufnahmen in den Behandlungsstationen aufgenommen werden, welche den Innenbereich gegenüber der Umgebung abdichten. Auf diese Weise kann das Prozeßgas dann nur in den Innenbereich geleitet werden. Bei geeigneter Druckeinstellung kommt es dann nur dort zur Zündung eines Plasmas.

Das Prozeßgas kann während des Beschichtens auch mit einer ersten Pumpeinrichtung abgesaugt werden. Wird gleichzeitig neues Prozeßgas zugeführt, so wird eine ständige Regeneration der Prozeßgasatmosphäre während des Beschichtungsvorgangs erreicht. Dabei werden im Plasma entstehende unerwünschte Reaktionsprodukte ständig abgeführt, wodurch besonders reine und qualitativ hochwertige Beschichtungen hergestellt werden können.

Die Erfindung wird nachfolgend genauer anhand beispielhafter Ausführungsformen und unter Bezugnahme auf die beigefügten Zeichnungen beschrieben. Dabei verweisen gleich Bezugszeichen auf gleiche oder ähnliche Teile.

Es zeigen:

Fig. 1A          eine Ansicht einer Ausführungsform der erfindungsgemäßen Rundläufervorrichtung,
Fig. 1B          eine Ansicht einer weiteren Ausführungsform der erfindungsgemäßen Rundläufervorrichtung,
Fig. 2           eine schematische Aufsicht auf Teile einer erfindungsgemäßen Rundläufervorrichtung,
Fig. 3           ein Vakuumschema für eine Ausführungsform einer mehrstufigen Vakuumbeschaltung einer erfindungsgemäßen Rundläufervorrichtung, und
Fig. 4A und 4B   eine weitere Ausführungsform eines Vakuumschemas mit mehreren gleichwertigen Pumpeinrichtungen.

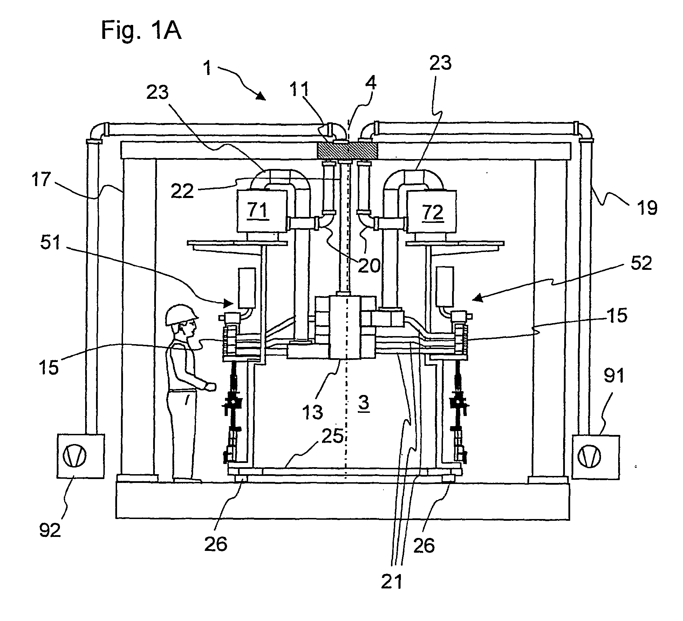

In Fig. 1A ist eine schematisch Ansicht einer erfindungsgemäßen Rundläufervorrichtung dargestellt, die als Ganzes mit 1 bezeichnet ist.

Die Rundläufervorrichtung 1 weist ein Förderkarussell 3 auf, auf dem mehrere Behandlungsstationen montiert sind, von denen zwei Behandlungsstationen 51 und 52 in der Zeichnung dargestellt sind. Das Förderkarussell 3 ist in einem Tragrahmen oder Traggestell 17 drehbar montiert. Dazu ist das Förderkarussell 3 auf einer Tragplatte 25 aufgebaut, die ihrerseits auf Drehlagern 26 gelagert ist und so im Tragrahmen 17 um die Drehachse 4 rotieren kann.

Ebenfalls auf dem Förderkarussell 3 montiert sind mitrotierende erste Pumpeinrichtungen, von denen in der Zeichnung zwei erste Pumpeinrichtungen 71 und 72 eingezeichnet sind.

Zusätzlich weist die erfindungsgemäße Vorrichtung auch noch zweite, feststehende Pumpeinrichtungen auf, die über Vakuumleitungen oder Anschlußrohre 19 mit einer Drehzuführung 11 verbunden sind. Dabei sind in Fig. 1A zwei Pumpeinrichtungen 91, 92 beispielhaft dargestellt. Die Vorrichtung kann jedoch auch noch weitere zweite Pumpeinrichtungen aufweisen. Von der Drehzuführung 11 zweigen weitere Vakuumleitungen 20 des Förderkarussells 3 ab, die mit den Gasauslässen den ersten Pumpeinrichtungen 71 und 72 verbunden sind. Die feststehenden, zweiten Pumpeinrichtungen 91, 92,.. wirken so als Vorstufe für die ersten, mitrotierenden Pumpeinrichtungen 71 und 72. Dadurch, daß diese Pumpeinrichtungen als Vorstufe im Grobvakuum betrieben werden, sind auch die Anforderungen an die Drehzuführung 11 in Bezug auf die Leckrate und den Leitwert niedrig. Dies senkt sowohl die Kosten für die Fertigung einer solchen Vorrichtung, als auch bei geeigneter Konstruktion die Anfälligkeit der Drehzuführung. Eine Leckrate der Drehzuführung von der Größenordnung $10^{-1}$ mbar 1/sec oder kleiner, bevorzugt im Bereich zwischen $10^{-2}$ bis $10^{-4}$ mbar 1/sec bei ruhendem und/oder drehendem Betrieb kann dabei gemäß einer Ausführungsform der Erfindung noch toleriert werden.

Dadurch, daß die zweiten, feststehenden Pumpeinrichtungen verglichen mit den ersten, mitrotierenden Pumpeinrichtungen in höheren Druckbereichen arbeiten, ist auch der Leitwert der Vakuumleitungen 19 bei gegebenem Durchmesser beispielsweise gemäß der Gleichungen (2) und (3) für laminare Strömung höher als bei Druckbereichen, bei welchen die ersten, mitrotierenden Pumpeinrichtungen verwendet werden. Dementsprechend wirken sich die durch die feststehende Anordnung bedingten größeren Längen der Vakuumleitungen 19 und die in der Vakuumverbindung befindliche Drehzuführung 13 bei diesen Pumpeinrichtungen 91, 92 nicht so stark auf deren Pumpvermögen aus, wie dies bei einer feststehenden Anordnung der ersten Pumpeinrichtungen der Fall wäre.

Die ersten Pumpeinrichtungen 71 und 72 sind über Vakuumleitungen oder Kopplungsleitungen 23 mit großem Querschnitt an einem Ringverteiler 13 angeschlossen. Von diesem zweigen Verteilungsleitungen oder Anschlußleitungen 21 ab, die mit Steuerventilen 15 verbunden sind. Die Steuerventile 15 sind ihrerseits mit den Beschichtungskammern 51, 52 gekoppelt. Der Ringverteiler 13 und die Steuerventile sind demgemäß Bestandteile einer Verteilereinrichtung, welche die Verbindung der Pumpeinrichtungen mit den Behandlungsstationen herstellt.

Bei Rotation des Förderkarussels 2 sind den einzelnen Bearbeitungsphasen bei der Beschichtung, wie etwa dem Einführen, Evakuieren Beschichten und Entnehmen bestimmte Winkelbereiche zugeordnet, welche die jeweilige Behandlungsstation 51, 52 durchläuft. Dabei wird das Verbinden einer Behandlungsstation 51, 52 mit einer ersten Pumpeinrichtung 71, 72 und auch das Trennen von dieser durch Schalten der Steuerventile 15 bewerkstelligt.

Die einzelnen mitrotierenden ersten Pumpeinrichtungen 71 und 72 können dabei insbesondere auch auf unterschiedlichen Druckstufen arbeiten. Dann kann das Evakuieren der Behandlungsstationen in mehreren Stufen erfolgen, wobei zu jeder Stufe von einer Pumpe auf einer höheren Druckstufe auf eine Pumpe auf niedrigerer Druckstufe umgeschaltet wird. Dementsprechend werden die Pumpeinrichtungen 71 und 72 bei Drehung des Förderkarussels nacheinander mit den Behandlungsstationen verbunden. Auch das Umschalten zwischen den Pumpeinrichtungen 71 und 72 erfolgt dabei vorzugsweise durch die Steuerventile 15. Die Ansteuerung der Steuerventile 15 kann beispielsweise durch mechanische Steuerkurven erfolgen, an denen die auf dem Förderkarussell montierten Steuerventile 15 vorbeibewegt werden. Ebenso können die Ventile aber auch elektromechanisch ausgeführt sein, wobei das Schalten dieser Ventile dann durch An- und Ausschalten von Schaltströmen.

Beim mehrstufigen Abpumpen können die zweiten, feststehenden Pumpeinrichtungen nicht nur als Vorstufe für die mitrotierenden, ersten Pumpeinrichtungen 71, 72 dienen. Es ist auch möglich, daß insbesondere in der Anfangsphase der Evakuierung auch die Behandlungsstation mit zumindest einer feststehenden zweiten Pumpeinrichtung verbunden wird. Dies ist zum Beispiel sinnvoll, um die Behandlungsstation von Atmosphärendruck auf Grobvakuum abzupumpen. Dazu ist bei der in Fig. 1A gezeigten Ausführungsform eine Vakuumleitung 22 vorgesehen, welche den Ringverteiler 13 über die Drehzuführung 11 mit der feststehenden zweiten Pumpeinrichtung 92 verbindet. Vom Ringverteiler 13 aus können dann mittels der Steuerventile 15 die Beschichtungskammern 51, 52 mit der Pumpeinrichtung 92 in einer ersten Stufe der Evakuierung zur Erreichung eines Grobvakuums verbunden werden.

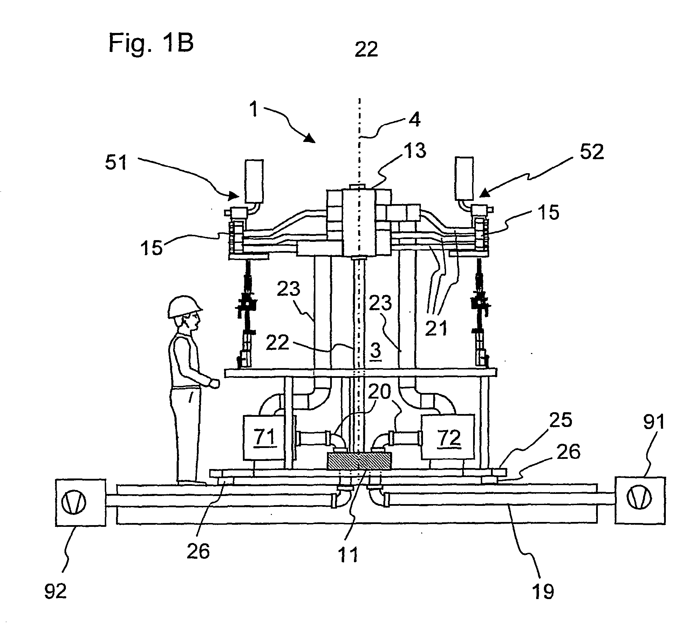

Fig. 1B zeigt eine weitere Ausführungsform einer erfindungsgemäßen Vorrichtung. Bei dieser Ausführungsform ist die Drehzuführung 11 unterhalb des Ringverteilers 13 angeordnet. Auf diese Weise können die Pumpeinrichtungen 91 und 92 in Bodennähe angeordnet und mit im Verhältnis zum Durchmesser besonders kurzen Vakuumleitungen mit der Drehzuführung 11 verbunden werden. Dadurch lassen sich auch sehr hohe Leitwerte der Vakuumverbindung von den mit dem Förderkarussell 3 mitrotierenden ersten Pumpeinrichtungen 71, 72 und dem Ringverteiler 13 zu den feststehenden zweiten Pumpeinrichungen 91, 92 erreichen. Diese Vakuumverbindung umfaßt die Vakuumleitungen 19 von den Pumpeinrichtungen 91, 92 zur Drehzuführung 11 und die von der Drehzuführung ausgehenden Vakuumleitungen 20 und 22 zu den Pumpeinrichtungen 71, 72, beziehungsweise dem Ringverteiler 13.

Bei der erfindungsgemäßen Vorrichtung, wie sie beispielhaft in den Fig. 1A und 1B dargestellt ist, lassen sich Leitwerte erreichen, bei welchen das effektive Saugvermögen der Pumpeinrichtungen, die jeweils über die Vakuumverbindung pumpen, nur wenig gegenüber dem tatsächlichen maximalen Saugvermögen der Pumpeinrichtungen reduziert ist. Dies wird durch die erfindungsgemäße Anordnung mit mitrotierenden ersten Pumpeinrichtungen insbesondere auch für die Vakuumverbindung zu den Behandlungsstationen 51, 52 erreicht, da die Pumpeinrichtungen entsprechend nahe an den Behandlungsstationen angeordnet und die Vakuumleitungen kurz gehalten werden können. So können die Vakuumleitungen 23 zwischen erster Pumpeinrichtung 71, 72 und Ringverteiler 13 beipielsweise so kurz dimensioniert werden, daß der Quotient aus Durchmesser d der Vakuumleitung 23 zu deren Länge 1 größer oder gleich 1/15, oder sogar größer oder gleich 1/10 beträgt. Würden bei den anhand von Fig. 1A oder 1B dargestellten Ausführungsformen die Pumpeinrichtungen, anstelle mitzurotieren, feststehend montiert und mit den Behandlungsstationen über eine Drehzuführung verbunden sein, so wären deutlich längere Vakuumleitungen erforderlich. Bei gleichem Durchmesser würde konstruktionsbedingt der Quotient d/l aus Durchmesser d und Leitungslänge 1 nur noch 1/60 oder weniger betragen. Beispielsweise wären bei einem Leitungsdurchmesser von 10 Zentimetern Leitungslängen von etwa 6 Metern notwendig, während sich durch die mitrotierende Anordnung diese Länge auf etwa 1 bis 1,5 Meter oder sogar weniger reduzieren läßt. Zusätzlich können auf diese Weise auch Umlenkungen der Leitungen reduziert werden, wie sie etwa bei langen Vakuumverbindungen notwendig werden können. Jede 90° Umlenkung entspricht beispielsweise bezüglich des Leitwerts bei einer Leitung mit 10 Zentimetern Durchmesser einer zusätzlichen Verlängerung der Leitung um etwa 0,3 Meter.

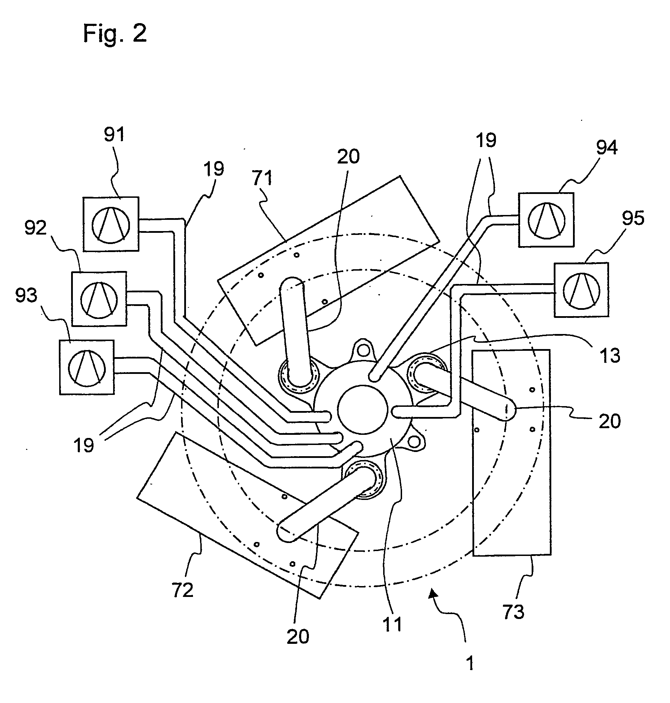

In Fig. 2 ist eine schematische Aufsicht auf Teile einer Rundläufervorrichtung 1 gezeigt. Diese Ausführungsform der Rundläufervorrichtung weist drei mitrotierende erste Pumpeinrichtungen 71, 72, 73 auf, die mit dem Ringverteiler 13 verbunden sind. Bevorzugt werden für die ersten Pumpeinrichtungen Wälzkolbenpumpen eingesetzt, die durch ein großes Saugvermögen bei niedrigen Drücken gekennzeichnet sind. Derartige Pumpen weisen andererseits nur ein geringes Kompressionsvermögen auf, so daß zur Erreichung niedriger Enddrücke nach abgeschlossener Evakuierung im allgemeinen Vorstufen notwendig sind. Diese werden, wie bereits oben erläutert, durch zweite, feststehende Pumpeinrichtungen bereitgestellt, die über eine Drehzuführung 11 mit den Pumpeinrichtungen 71, 72 und 73 verbunden sind.

Im einzelnen weist die in Fig. 2 dargestellte Ausführungsform der Rundläufervorrichtung 1 insgesamt fünf solcher feststehenden Pumpeinrichtungen 91 bis 95 auf. Die Pumpeinrichtungen 91 bis 95 müssen dabei nicht alle vom gleichen Typ sein. Diese können sich vielmehr hinsichtlich ihrer Saugleistung und des optimalen Druckbereichs unterscheiden. Vorzugsweise werden für die Pumpeinrichtungen 91 bis 95 Drehschieberpumpen eingesetzt, die hohe Saugleistungen im Grobvakuumbereich aufweisen.

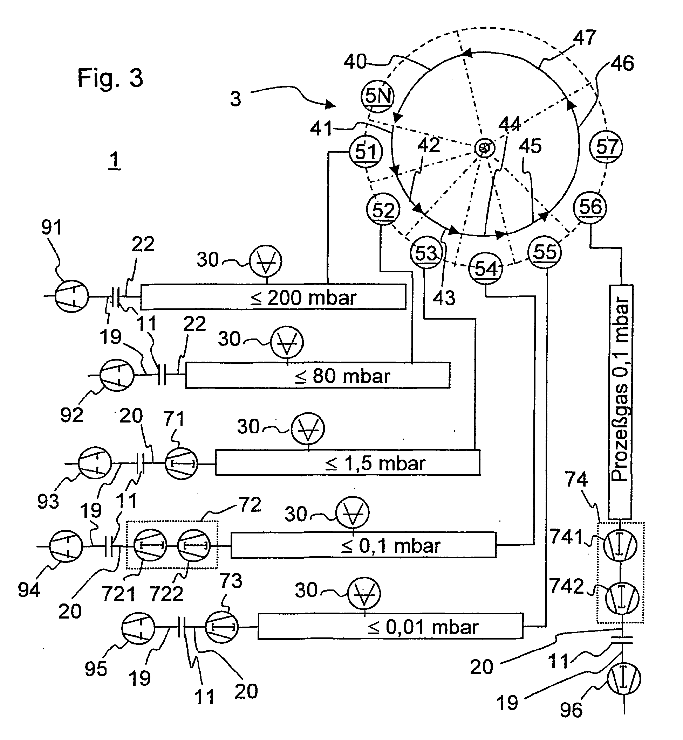

In Fig. 3 ist ein Vakuumschema für eine Ausführungsform einer mehrstufigen Vakuumbeschaltung einer erfindungsgemäßen Rundläufervorrichtung dargestellt. Bei dieser Ausführungsform der Erfindung wird das Evakuieren in vier oder fünf Schritten durchgeführt. Während der Beschichtungsphase wird nach der Evakuierung außerdem das Prozeßgas abgepumpt. Den zusammen mit dem Abpumpen des Prozeßgases insgesamt sechs einzelnen Evakuierungsphasen sind Winkelbereiche oder Sektoren 41 bis 46 zugeordnet, durch welche sich die einzelnen Behandlungsstationen 51, 52, ..., 5N auf dem Förderkarussell 3 durch die Rotation des Karussells hindurchbewegen. In jedem der Sektoren 41 bis 46 wird jeweils eine Behandlungsstation mit einer einzelnen Pumpeinrichtung oder mit mehrstufigen Pumpeinrichtungen verbunden. Während des gesamten Evakuierungsprozesses einschließlich des Abpumpens von Prozeßgas ist dabei jede der Pumpeinrichtungen nur mit jeweils einer Behandlungsstation verbunden. Beim Verlassen eines einer bestimmten Evakuierungsphase zugeordneten Winkelbereichs, beziehungsweise vor dem Eintritt in den darauffolgenden Winkelbereich wird die Verbindung der Behandlungsstation zu einer Pumpeinrichtung dann wieder getrennt. Das Verbinden und Trennen kann dabei ebenfalls mittels einer Verteilereinrichtung geschehen, die Steuerventile und einen Ringverteiler umfaßt. Die Drücke können dabei mit geeigneten Druckmeßröhren 30, beispielsweise Pirani-Meßröhren gemessen und überprüft werden.

Nach dem Zuführen der Werkstücke in einem Beladebereich, der einem Sektor 40 zugeordnet ist, wird die Behandlungsstation während des Durchlaufens durch den Sektor 41 mit einer feststehenden zweiten Pumpeinrichtung 91 verbunden, welche den Beschichtungsbereich der Behandlungsstation auf einen Druck von ≤ 200 mbar abpumpt. Befindet sich eine Behandlungsstation im darauffolgenden Sektor 42 wird eine Verbindung zu einer weiteren feststehenden Pumpeinrichtung 92 hergestellt, die für einen niedrigeren Druckbereich optimiert ist. Während des Durchlaufens dieses Sektors pumpt die Pumpeinrichtung 92 den Beschichtungsbereich der Behandlungsstation auf einen Druck von ≤ 80 mbar ab. Um in weiteren Evakuierungsphasen noch niedrigere Drücke zu erreichen, werden daraufhin mitrotierende erste Pumpeinrichtungen 71, 72 und bei Evakuierung in fünf Stufen auch eine optionale weitere erste Pumpeinrichtungen 73 verwendet, so daß kurze Zuleitungen mit großem Querschnitt verwendet und Schwierigkeiten bei der Abdichtung der Drehzuführung vermieden werden können. Dabei werden die Behandlungsstationen während des Durchlaufens der Winkelbereiche 53, 54 und 55 auf kleiner gleich 1,5 mbar, kleiner gleich 0,1 mbar, beziehungsweise im Falle einer Evakuierung in fünf Schritten kleiner gleich 0,01 mbar abgepumpt, so daß der Druck in jeder der Evakuierungsphasen jeweils um etwa eine Größenordnung erniedrigt wird.

Um eine hohe Maschinenleistung, beziehungsweise einen großen Durchsatz zu erreichen, ist die Zeit zwischen dem Beladen zweier Behandlungsstationen sehr kurz. Entsprechend kurz können auch die Abpumpzeiten gehalten werden. Die fein unterteilte Abstufung des Evakuierungsprozesses ist hierbei von großem Vorteil, da die dazu erforderlichen Pumpen relativ klein gehalten werden können.

Außerdem sind den ersten Pumpeinrichtungen 71, 72 und 73 zweite, feststehende Pumpeinrichtungen 93, 94 und 95 als Vorstufe vorgeschaltet, so daß das Pumpen zweistufig erfolgt, um große Kompressionsverhältnisse über einzelnen Pumpen abzubauen oder zu vermeiden.

Die feststehenden zweiten Pumpeinrichtungen 91 bis 94 sind jeweils als Drehschieberpumpen ausgeführt, die sich gut für das Pumpen gegen Atmosphärendruck eignen. Demgegenüber umfassen alle mitrotierenden ersten Pumpeinrichtungen 71 bis 74 Wälzkolbenpumpen, um große Saugleistungen bei niedrigen Drücken bereitzustellen.

Die Pumpeinrichtungen 72 und 74 sind zusätzlich zweistufig ausgeführt und umfassen jeweils Wälzkolbenpumpen 721, 722, beziehungsweise 741, 742.

Nach dem Durchlaufen der Sektoren 41 bis 45 ist die Evakuierung auf den Enddruck abgeschlossen und die Beschichtungskammer durchläuft einen der Beschichtung zugeordneten Winkelbereich 46. Hier wird Prozeßgas in den Beschichtungsbereich eingelassen und Mikrowellen zugeführt, wodurch ein Plasma gezündet und das in der Behandlungsstation befindliche Werkstück beschichtet. Während dieser Bearbeitungsphase wird die Beschichtungsanlage mit der zweistufig ausgelegten Pumpeinrichtung 74 verbunden, die ebenfalls wie die übrigen ersten Pumpeinrichtungen an einer zweiten feststehenden Pumpeinrichtung angeschlossen ist. Um die großen anfallenden Gasmengen zu beseitigen, umfaßt hier auch die Vorstufe, beziehungsweise die feststehende zweite Pumpeinrichtung 96 eine Wälzkolbenpumpe.

Nach abgeschlossener Beschichtung gelangt die Behandlungsstation in einen dem Sektor 47 zugeordneten Entnahmebereich, wo das beschichtete Werkstück herausgenommen und mittels einer geeigneten Transporteinrichtung abtransportiert wird. Ebenso wie das Beladen der Behandlungsstationen kann auch die Entnahme durch in Fig. 3 nicht dargestellte Zuteilräder geschehen.

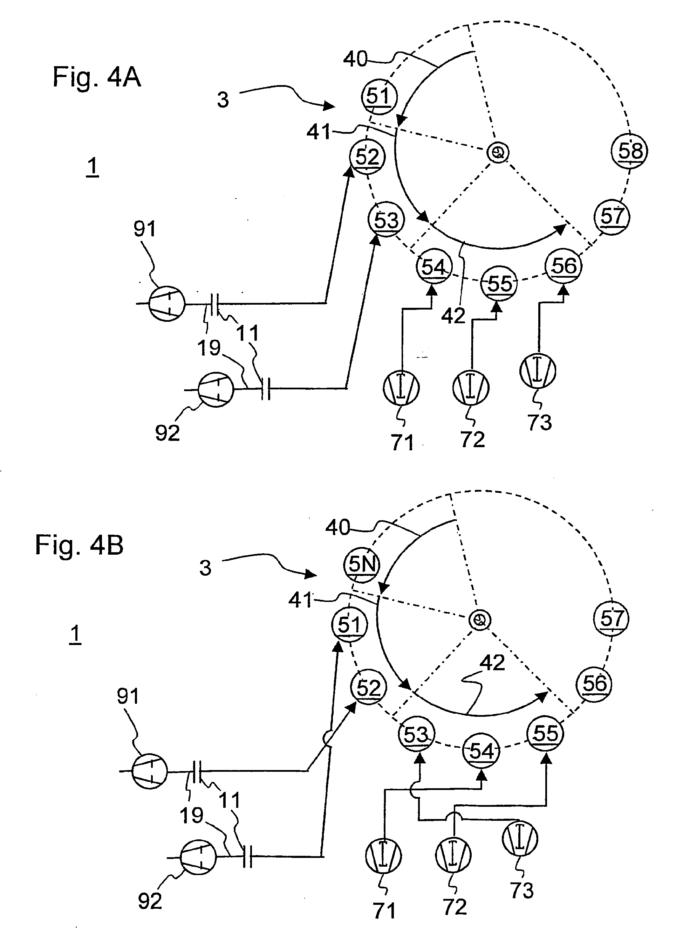

In den Fig. 4A und 4B ist ein Vakuumschema einer weiteren Ausführungsform der Erfindung zu zwei verschiedenen Zeitpunkten gezeigt, wobei in diesen Figuren vereinfachend nur das Vakuumschema für die Evakuierung der Beschichtungsstationen dargestellt ist. Bei der anhand dieses Vakuumschemas dargestellten Ausführungsform der Erfindung werden mehrere gleichwertige Pumpeinrichtungen für einzelne Evakuierungsphasen eingesetzt, um die Pumpleistung weiter zu erhöhen. Dabei sind die mitrotierenden ersten Pumpeinrichtungen 71, 72 und 73 bei dieser Ausführungsform gleichwertig ausgeführt. Auch die feststehenden zweiten Pumpeinrichtungen 91 und 92 sind gleichwertig und arbeiten dementsprechend bei gleichem Druck mit gleicher Pumpleistung.

Das Evakuieren der Behandlungsstationen 51, 52,...,5N erfolgt gemäß dieser Ausführungsform der Erfindung während einer ersten, dem Sektor 41 zugeordneten Evakuierungsphase mit den gleichwertigen Pumpeinrichtungen 91, 92 und während einer zweiten Evakuierungsphase, die dem Sektor 42 zugeordnet ist, mit den gleichwertigen mitrotierenden ersten Pumpeinrichtungen 71, 72, 73.

Im speziellen wird dabei jeweils eine der gleichwertigen Pumpeinrichtungen 91, 92, beziehungsweise 71, 72, 73 mit zumindest einer Behandlungsstation für die Dauer der jeweiligen, den Sektoren 41, beziehungsweise 42 zugeordneten Evakuierungsphase verbunden.

Das Verbinden der Behandlungsstationen 51, 52,...,5N erfolgt dabei mit einer Verteilereinrichtung, die, wie anhand der Fig. 1A und 1B erläutert, einen Ringverteiler 13 und Ventile 15 umfassen kann.

Die Behandlungsstationen werden jeweils beim Eintritt in einen der Sektoren 41, 42 mit eine der gleichwertigen Pumpeinrichtungen 91, 92, beziehungsweise 71 - 73 für die Dauer der jeweiligen Evakuierungsphase, also für die Dauer des Durchlaufens der Sektoren oder Kreissegmente 41, beziehungsweise 42 verbunden.

Bei der in Fig. 4A gezeigten Stellung des Förderkarussells 3 ist die Behandlungsstation 52 mit der Pumpeinrichtung 91, die Behandlungsstation 53 mit der Pumpeinrichtung 92, die Behandlungsstation 54 mit der Pumpeinrichtung 71, die Behandlungsstation 55 mit der Pumpeinrichtung 72 und die Behandlungsstation 56 mit der Pumpeinrichtung 73 verbunden.

Bei der in Fig. 4B gezeigten Stellung hat sich das Förderkarussell 3 weitergedreht, so daß die Behandlungsstation 51 in den Winkelbereich 41 eingetreten ist. Gleichzeitig hat die Behandlungsstation 53 die dem Winkelbereich 41 zugeordnete Evakuierungsphase abgeschlossen und ist in den anschließenden, einer weiteren Evakuierungsphase zugeordneten Sektor 42 eingetreten, wo die Behandlungsstation 53 mit der mitrotierenden Pumpeinrichtung 73 verbunden worden ist. Die vorher mit dieser Behandlungsstation 53 verbundene Pumpeinrichtung 92 wurde bei Beendigung der dem Sektor 41 zugeordneten Evakuierungsphase von dieser Station getrennt und dann mit der neu in den Sektor 41 eingetretenen Behandlungsstation 51 verbunden.

In analoger Weise erfolgt dabei auch das Verbinden und Trennen der Pumpeinrichtungen 71 - 73 beim Durchlaufen des Sektors 42, beziehungsweise zu Beginn und Ende der diesem Sektor zugeordneten Evakuierungsphase, wobei das Verbinden der Pumpeinrichtungen 91 und 92, beziehungsweise 71, 72 und 73 für die Dauer der jeweiligen Evakuierungsphase zyklisch erfolgt, beziehungsweise zyklisch fortgesetzt wird.

Abweichend von der anhand der Fig. 4A und 4B dargestellten Ausführungsform der Erfindung können anstelle einzelner Behandlungsstationen auch jeweils Gruppen von mindestens zwei Behandlungsstationen jeweils mit einer Pumpeinrichtung verbunden werden, die dann jeweils gruppenweise evakuiert werden.

Bezugszeichenliste

| | |
|---|---|
| 1 | Rundläufervorrichtung |
| 3 | Förderkarussell |
| 4 | Drehachse |
| 51, 52, .., 5N | Behandlungsstationen |
| 71 - 74 | erste, mitrotierende Pumpeinrichungen |
| 721, 722, 741, 742 | Wälzkolbenpumpen |
| 91 - 96 | zweite, feststehende Pumpeinrichtungen. |
| 11 | Drehzuführung |
| 13 | Ringverteiler |
| 15 | Steuerventile |
| 17 | Tragrahmen |
| 19 - 23 | Vakuumleitungen |
| 25 | Trageplatte |
| 26 | Lager |
| 30 | Druckmeßröhre |
| 40 - 47 | Winkelbereiche |

**Patentansprüche**

1. Rundläufervorrichtung (1) zur Behandlung, insbesondere für CVD-Beschichtungen von Werkstücken mit

    - einem Förderkarussell (3),
    - Behandlungsstationen (51, 52,..., 5N), welche mit dem Förderkarussell (3) transportiert werden, und
    - zumindest einer ersten Pumpeinrichtung (71 - 74), sowie
    - zumindest einer Verteilereinrichtung (13, 15),

    **dadurch gekennzeichnet, daß** die erste Pumpeinrichtung (71 - 74) mit dem Förderkarussell transportiert wird, **gekennzeichnet durch** wenigstens eine Verteilereinrichtung (13, 15) zur Verbindung der Behandlungsstationen (51, 52,..., 5N) mit der Pumpeinrichtung (71 - 74) dient, wobei die Verteilereinrichtung (13, 15) eingerichtet ist, während des Evakuierens die Pumpeinrichtung (71 - 74, 91 - 96) nur mit jeweils einer Behandlungsstation (51, 52,..., 5N) zu verbinden.

2. Rundläufervorrichtung nach Anspruch 1,
    **dadurch gekennzeichnet, daß**
    die Verteilereinrichtung (13, 15) einen Ringverteiler (13) umfaßt.

3. Rundläufervorrichtung nach Anspruch 1 oder 2,
    **dadurch gekennzeichnet, daß**
    die Verteilereinrichtung (13, 15) Steuerventile (15) umfaßt.

4. Rundläufervorrichtung nach einem der Ansprüche 1 bis 3,
    **dadurch gekennzeichnet, daß**
    die erste Pumpeinrichtung (71 - 74) zumindest eine Wälzkolbenpumpe umfaßt.

5. Rundläufervorrichtung nach einem der Ansprüche 1 bis 4, **dadurch gekennzeichnet, daß** der Quotient aus Durchmesser d einer Vakuumleitung zwischen erster Pumpeinrichtung und einer Verteilereinrichtung (13, 15) zu deren Länge 1 größer oder gleich 1/15, bevorzugt größer oder gleich 1/10 beträgt.

6. Rundläufervorrichtung.nach einem der Ansprüche 1 bis 5, **gekennzeichnet durch**
    zumindest eine feststehend angeordnete zweite Pumpeinrichtung (91 - 96).

7. Rundläufervorrichtung nach Anspruch 6,
    **dadurch gekennzeichnet, daß**
    die erste und zweite Pumpeinrichtung (71 - 74, 91 - 96) für unterschiedliche Druckbereiche angepaßt sind.

8. Rundläufervorrichtung nach Anspruch 6 oder 7,
    **dadurch gekennzeichnet, daß**
    die zweite Pumpeinrichtung (91 - 96) als Vorstufe der ersten Pumpeinrichtung (71 - 74) angeschlossen ist.

9. Rundläufervorrichtung nach einem der Ansprüche 6 bis 8,
    **dadurch gekennzeichnet, daß**
    die zweite Pumpeinrichtung (91 - 96) zumindest eine Drehschieberpumpe umfaßt.

10. Rundläufervorrichtung nach einem der Ansprüche 6 bis 9,
    **dadurch** gekenntzeichnet, daß
    die zweite Pumpeinrichtung mittels einer Drehzuführung (11) mit dem Förderkarussell (3) verbunden ist.

11. Rundläufervorrichtung nach Anspruch 10, **dadurch gekennzeichnet, daß** die Leckrate der Drehzuführung $10^{-1}$ mbar 1 /sec oder kleiner, bevorzugt im Bereich zwischen $10^{-2}$ bis $10^{-4}$ mbar l / sec bei ruhendem und/oder drehendem Betrieb ist.

12. Rundläufervorrichtung nach einem der Ansprüche 6 bis 11, **dadurch gekennzeichnet, daß** die zweite, feststehende Pumpeinrichtung (91 - 96) mit wenigstens einer Verteilereinrichtung (13, 15) zur Verbindung der Behandlungsstationen (51, 52,..., 5N) mit der Pumpeinrichtung (91 - 96) verbunden ist.

**13.** Rundläufervorrichtung nach einem der Ansprüche 6 bis 12, **gekennzeichnet durch**
zumindest zwei feststehende zweite Pumpeinrichtungen (91, 92), welche bei Drehung des Förderkarussels (3) nacheinander mit den Behandlungsstationen (51, 52,..., 5N) verbunden werden.

**14.** Rundläufervorrichtung nach einem der Ansprüche 1 bis 13, **gekennzeichnet durch**
zumindest zwei erste Pumpeinrichtungen (71 - 74), welche bei Drehung des Förderkarussels nacheinander mit den Behandlungsstationen (51, 52,..., 5N) verbunden werden.

**15.** Rundläufervorrichtung nach einem der Ansprüche 1 bis 14, **gekennzeichnet durch**
eine erste Pumpeinrichtung (74) zur Abfuhr von Prozeßgas.

**16.** Rundläufervorrichtung nach einem der Ansprüche 1 bis 15,
**dadurch gekennzeichnet, daß**
die erste Pumpeinrichtung (72, 74) zumindest zwei hintereinandergeschaltete Pumpstufen (721, 722, 741, 742) umfaßt.

**17.** Rundläufervorrichtung nach einem der vorstehenden Ansprüche, **dadurch gekennzeichnet, daß** die Vorrichtung zumindest zwei gleichartige oder gleichwertige Pumpeinrichtungen umfaßt.

**18.** Rundläufervorrichtung nach Anspruch 17,
**gekennzeichnet durch** eine Verteilereinrichtung (13, 15) zur Verbindung der Behandlungsstationen (51, 52,..., 5N) mit den Pumpeinrichtungen (71 - 74), welche jeweils eine der gleichartigen oder gleichwertigen Pumpeinrichtungen mit zumindest einer Behandlungsstation für die Dauer einer Evakuierungsphase verbindet.

**19.** Rundläufervorrichtung nach einem der vorstehenden Ansprüche, **gekennzeichnet durch**
eine Einrichtung zur Zuführung von Prozeßgas in die Behandlungsstationen (51, 52,..., 5N).

**20.** Rundläufervorrichtung nach einem der vorstehenden Ansprüche, **gekennzeichnet durch**
eine Einrichtung zur Zuführung von elektromagnetischer Energie, vorzugsweise von Mikrowellen.

**21.** Verfahren zur CVD-Beschichtung von Werkstücken in einer Rundläufervorrichtung (1), insbesondere gemäß einem der vorstehenden Ansprüche, wobei

- wenigstens ein Werkstück in eine Behandlungsstation (51, 52,..., 5N) auf einem rotierenden Förderkarussell (3) eingeführt,
- die Behandlungsstation (51, 52,..., 5N) über zumindest eine Verteilereinrichtung (13, 15) mit zumindest einer ersten Pumpeinrichtung (71 - 74) verbunden,
- die Behandlungsstation (51, 52,..., 5N) evakuiert, und
- das Werkstück beschichtet wird,

wobei
die erste Pumpeinrichtung (71 - 74) mit dem Förderkarussell (3) befördert wird,
**dadurch gekennzeichnet, daß** mittels der wenigstens einen Verteilereinrichtung (13, 15) zur Verbindung der Behandlungsstationen (51, 52,..., 5N) mit der ersten Pumpeinrichtung (71 - 74) während des Evakuierens die Pumpeinrichtung (71 - 74, 91 - 96) nur mit jeweils einer Behandlungsstation (51, 52,..., 5N) verbunden wird.

**22.** Verfahren nach Anspruch 21, **dadurch gekennzeichnet, daß**
das Werkstück durch Zuführen von Prozeßgas und elektromagnetischer Energie in die Behandlungsstation (51, 52,..., 5N) beschichtet wird.

**23.** Verfahren nach einem der vorstehenden Ansprüche 21 oder 22, **gekennzeichnet durch** die Schritte des Belüftens und Herausnehmens des Werkstücks.

**24.** Verfahren nach einem der vorstehenden Ansprüche 21-23, wobei die Behandlungsstation (51, 52,..., 5N) mit zumindest einer feststehenden zweiten Pumpeinrichtung (91, 92) verbunden wird.

**25.** Verfahren nach Anspruch 24, **dadurch gekennzeichnet, daß**
die Pumpeinrichtungen (71 - 74, 91 - 96) nacheinander mit den Behandlungsstationen (51, 52,..., 5N) verbunden werden.

26. Verfahren nach Anspruch 24 oder 25, **dadurch gekennzeichnet, daß** die zweite Pumpeinrichtung (93 - 96) als Vorstufe zur ersten Pumpeinrichtung (71 - 74) betrieben wird.

27. Verfahren nach einem der vorstehenden Ansprüche 21-26, **dadurch gekennzeichnet, daß**
während der Beschichtung mit einer ersten Pumpeinrichtung (74) Prozeßgas abgesaugt wird.

28. Verfahren nach einem der vorstehenden Ansprüche 21-27,
**dadurch gekennzeichnet, daß**
während des Evakuierens wenigstens zeitweise zwei oder mehr erste Pumpeinrichtungen (71, 72, 73) hintereinandergeschaltet werden.

29. Verfahren nach einem der vorstehenden Ansprüche 21-28,
**dadurch gekennzeichnet, daß**
das Verbinden der Behandlungsstationen (51, 52,..., 5N) mit der ersten (71, 72, 73) oder zweiten Pumpeinrichtung (91, 92) durch Schalten von Steuerventilen (15) erfolgt.

30. Verfahren nach einem der vorstehenden Ansprüche 21-29,
**dadurch gekennzeichnet, daß**
das Evakuieren in wenigstens zwei Schritten erfolgt.

31. Verfahren nach Anspruch 31, **dadurch gekennzeichnet, daß**
zwischen den Schritten zwischen verschiedenen Pumpeinrichtungen (71, 72, 73, 91, 92) umgeschaltet wird.

32. Verfahren nach Anspruch 32, mit vier oder fünf Evakuierungssschritten.

33. Verfahren nach Anspruch 32, wobei der Druck in einer Behandlungsstation stufenweise in einem ersten Schritt bis auf $\leq 200$mbar, in einem darauffolgenden zweiten Schritt bis auf $\leq 80$ mbar, in einem darauffolgenden dritten Schritt bis auf $\leq 1,5$ mbar, in einem darauffolgenden vierten Schritt bis auf $\leq 0,1$ mbar und bei Evakuierung in fünf Schritten in einem darauffolgenden fünften Schritt bis auf $\leq 0,01$ mbar reduziert wird.

34. Verfahren nach einem der vorstehenden Ansprüche 21-33, **dadurch gekennzeichnet, daß** das Evakuieren der Behandlungsstationen während wenigstens einer Evakuierungsphase mit zumindest zwei gleichartigen oder gleichwertigen Pumpeinrichtungen erfolgt.

35. Verfahren nach Anspruch 34, **dadurch gekennzeichnet, daß** jeweils eine der gleichartigen oder gleichwertigen Pumpeinrichtungen mit zumindest einer Behandlungsstation für die Dauer der wenigstens einen Evakuierungsphase verbunden wird.

36. Verfahren nach einem der vorstehenden Ansprüche 21-35, wobei die Werkstücke hohlkörperförmig sind,
**dadurch gekennzeichnet, daß**
das Werkstück durch Zündung eines Plasmas im Innenbereich der Werkstücke beschichtet wird.

**Claims**

1. Rotary machine (1) for treatment, in particular for CVD coatings of work pieces having

   - a conveyor carousel (3),
   - treatment stations (51, 52, ..., 5N) which are transported by the conveyor carousel (3), and
   - at least one first pump device (71 - 74), as well as
   - at least one distributor device (13, 15),

   **characterised in that** the first pump device (71 - 74) is transported by the conveyor carousel,
   **characterised by** at least one distributor device (13, 15) for connecting the treatment stations (51, 52, ..., 5N) to the pump device (71 - 74), wherein the distributor device (13, 15) is arranged to connect the pump device (71 - 74, 91 - 96) only to a respective treatment station (51, 52, ..., 5N) during the evacuation.

2. Rotary machine as claimed in claim 1, **characterised in that** the distributor device (13, 15) has an annular distributor (13).

3. Rotary machine as claimed in claim 1 or 2, **characterised in that** the distributor device (13, 15) has control valves (15).

4. Rotary machine as claimed in any one of claims 1 to 3, **characterised in that** the first pump device (71 - 74) has at least one Roots pump.

5. Rotary machine as claimed in any one of claims 1 to 4, **characterised in that** the quotient of the diameter d of a vacuum line between the first pump device and a distributor device (13, 15) to the length 1 thereof is greater than or equal to 1/15, preferably greater than or equal to 1/10.

6. Rotary machine as claimed in any one of claims 1 to 5, **characterised by** at least one fixedly disposed second pump device (91 - 96).

7. Rotary machine as claimed in claim 6, **characterised in that** the first and second pump device (71 - 74, 91 - 96) are adapted for different pressure ranges.

8. Rotary machine as claimed in claim 6 or 7, **characterised in that** the second pump device (91 - 96) is connected as a precursor of the first pump device (71- 74).

9. Rotary machine as claimed in any one of claims 6 to 8, **characterised in that** the second pump device (91 - 96) has at least one rotary vane pump.

10. Rotary machine as claimed in any one of claims 6 to 9, **characterised in that** the second pump device is connected to the conveyor carousel (3) by a rotary supply means (11).

11. Rotary machine as claimed in claim 10, **characterised in that** the leakage rate of the rotary supply means is $10^{-1}$ mbar 1/s or less, preferably in the range between $10^{-2}$ to $10^4$ mbar l/s during stationary and/or rotating operation.

12. Rotary machine as claimed in any one of claims 6 to 11, **characterised in that** the second fixed pump device (91 - 96) is connected to at least one distributor device (13, 15) for connection of the treatment stations (51, 52, ..., 5N) to the pump device (91 - 96).

13. Rotary machine as claimed in any one of claims 6 to 12, **characterised by** at least two fixed second pump devices (91, 92) which are connected in succession to the treatment stations (51, 52, ..., 5N) during rotation of the conveyor carousel (3).

14. Rotary machine as claimed in any one of claims 1 to 13, **characterised by** at least two first pump devices (71 - 74), which are connected in succession to the treatment stations (51, 52, ..., 5N) during rotation of the conveyor carousel.

15. Rotary machine as claimed in any one of claims 1 to 14, **characterised by** a first pump device (74) for discharging process gas.

16. Rotary machine as claimed in any one of claims 1 to 15, **characterised in that** the first pump device (72, 74) has at least two pump stages (721, 722, 741, 742) connected one behind the other.

17. Rotary machine as claimed in any one of the preceding claims, **characterised in that** the machine has at least two similar or equivalent pump devices.

18. Rotary machine as claimed in claim 17, **characterised by** a distributor device (13, 15) for connection of the treatment stations (51, 52, ..., 5N) to the pump devices (71 - 74), which connects in each case one of the similar or equivalent pump devices to at least one treatment station for the duration of an evacuation phase.

19. Rotary machine as claimed in any one of the preceding claims, **characterised by** a device for supplying process gas into the treatment stations (51, 52, ..., 5N).

20. Rotary machine as claimed in any one of the preceding claims, **characterised by** a device for supplying electromagnetic energy, preferably microwaves.

21. Method for CVD coating of work pieces in a rotary machine (1), in particular in accordance with any one of the preceding claims, wherein

    - at least one work piece is introduced into a treatment station (51, 52, ..., 5N) on a rotating conveyor carousel (3),
    - the treatment station (51, 52,..., 5N) is connected via at least one distributor device (13, 15) to at least one first pump device (71 - 74),
    - the treatment station (51, 52,..., 5N) is evacuated, and
    - the work piece is coated,

    wherein
    the first pump device (71 - 74) is conveyed by the conveyor carousel (3),
    **characterised in that** by means of the at least one distributor device (13, 15) for connection of the treatment stations (51, 52, ..., 5N) to the first pump device (71 - 74) the pump device (71 - 74, 91 - 96) is connected only to a respective treatment station (51, 52, ..., 5N) during the evacuation.

22. Method as claimed in claim 21, **characterised in that** the work piece is coated by the supply of process gas and electromagnetic energy into the treatment station (51, 52,.... 5N).

23. Method as claimed in any one of the preceding claims 21 or 22, **characterised by** the steps of ventilating and removing the work piece.

24. Method as claimed in any one of the preceding claims 21 - 23, wherein the treatment station (51, 52,... 5N) is connected to at least one fixed second pump device (91, 92).

25. Method as claimed in claim 24, **characterised in that** the pump devices (71 - 74, 91 - 96) are connected in succession to the treatment stations (51, 52, ..., 5N).

26. Method as claimed in claim 24 or 25, **characterised in that** the second pump device (93 - 96) is operated as a precursor to the first pump device (71 - 74).

27. Method as claimed in any one of the preceding claims 21-26, **characterised in that** process gas is drawn off by a first pump device (74) during coating.

28. Method as claimed in any one of the preceding claims 21 - 27, **characterised in that** at least from time to time during evacuation two or more first pump devices (71, 72, 73) are connected one behind the other.

29. Method as claimed in any one of the preceding claims 21 - 28, **characterised in that** the connection of the treatment stations (51, 52, ..., 5N) to the first (71, 72, 73) or second pump device (91, 92) takes place by the switching of control valves (15).

30. Method as claimed in any one of the preceding claims 21 - 29, **characterised in that** the evacuation takes place in at least two steps.

31. Method as claimed in claim 31 *[sic]*, **characterised in that** between the steps there is a switch-over between different pump devices (71, 72, 73, 91, 92).

32. Method as claimed in claim 32 *[sic]*, having four or five evacuation steps.

33. Method as claimed in claim 32, wherein the pressure in a treatment station is reduced stepwise in a first step to ≤ 200 mbar, in a successive second step to ≤ 80 mbar, in a successive third step to ≤ 1.5 mbar, in a successive fourth step to ≤ 0.1 mbar and, in the case of evacuation in five steps, in a successive fifth step to ≤ 0.01 mbar.

34. Method as claimed in any one of the preceding claims 21 - 33, **characterised in that** the evacuation of the treatment stations takes place during at least one evacuation phase with at least two similar or equivalent pump devices.

35. Method as claimed in claim 34, **characterised in that** in each case one of the similar or equivalent pump devices is connected to at least one treatment station for the duration of the at least one evacuation phase.

**36.** Method as claimed in any one of the preceding claims 21-35, wherein the work pieces are in the form of hollow bodies, **characterised in that** the work piece is coated by ignition of a plasma in the inner region of the work pieces.

**Revendications**

**1.** Dispositif de plateau tournant (1) pour le traitement, en particulier pour des revêtements CVD de pièces comprenant

- un carrousel transporteur (3),
- des stations de traitement (51, 52, ..., 5N), qui sont transportées avec le carrousel transporteur (3), et
- au moins un premier dispositif de pompage (71 - 74), et
- au moins un dispositif répartiteur (13, 15),

**caractérisé en ce que** le premier dispositif de pompage (71 - 74) est transporté avec le carrousel transporteur, **caractérisé par** au moins un dispositif répartiteur (13, 15) qui sert à la liaison des stations de traitement (51, 52 ..., 5N) avec le dispositif de pompage (71 - 74), le dispositif répartiteur (13, 15) étant aménagé pour relier pendant la mise sous vide le dispositif de pompage (71 - 74, 91 - 96) uniquement avec respectivement une station de traitement (51, 52, ..., 5N).

**2.** Dispositif de plateau tournant selon la revendication 1,
**caractérisé en ce que**
le dispositif répartiteur (13, 15) comprend un répartiteur annulaire (13).

**3.** Dispositif de plateau tournant selon la revendication 1 ou 2,
**caractérisé en ce que**
le dispositif répartiteur (13, 15) comprend des vannes de commande (15).

**4.** Dispositif de plateau tournant selon l'une quelconque des revendications 1 à 3,
**caractérisé en ce que**
le premier dispositif de pompage (71 - 74) comprend au moins une pompe Roots.

**5.** Dispositif de plateau tournant selon l'une quelconque des revendications 1 à 4, **caractérisé en ce que** le quotient du diamètre d d'une conduite à vide entre le premier dispositif de pompage et un dispositif répartiteur (13, 15) par sa longueur 1 est supérieur ou égal à 1/15, de préférence supérieur ou égal à 1/10.

**6.** Dispositif de plateau tournant selon l'une quelconque des revendications 1 à 5, **caractérisé par**
au moins un second dispositif de pompage (91 - 96) disposé de façon fixe.

**7.** Dispositif de plateau tournant selon la revendication 6,
**caractérisé en ce que**
les premier et second dispositifs de pompage (71 - 74, 91 - 96) sont adaptés pour différentes plages de pression.

**8.** Dispositif de plateau tournant selon la revendication 6 ou 7,
**caractérisé en ce que**
le second dispositif de pompage (91 - 96) est raccordé comme étage préliminaire du premier dispositif de pompage (71 - 74).

**9.** Dispositif de plateau tournant selon l'une quelconque des revendications 6 à 8,
**caractérisé en ce que**
le second dispositif de pompage (91- 96) comprend au moins une pompe à tiroir rotatif.

**10.** Dispositif de plateau tournant selon l'une quelconque des revendications 6 à 9,
**caractérisé en ce que**
le second dispositif de pompage est relié au moyen d'une arrivée rotative (11) au carrousel transporteur (3).

**11.** Dispositif de plateau tournant selon la revendication 10, **caractérisé en ce que** le taux de fuite de l'arrivée tournante

est de $10^{-1}$ mbar 1/sec ou moins, se situe de préférence dans la plage comprise entre $10^{-2}$ à $10^{-4}$ mbar l/sec lorsque le dispositif est au repos et/ou tourne.

12. Dispositif de plateau tournant selon l'une quelconque des revendications 6 à 11, **caractérisé en ce que** le second dispositif de pompage (91 - 96) fixe est relié à au moins un dispositif répartiteur (13, 15) pour la liaison des stations de traitement (51, 52 ..., 5N) avec le dispositif de pompage (91 - 96).

13. Dispositif de plateau tournant selon l'une quelconque des revendications 6 à 12, **caractérisé par**
au moins deux seconds dispositifs de pompage (91, 92) fixes, qui sont reliés en cas de rotation du carrousel transporteur (3) de façon successive aux stations de traitement (51, 52, ..., 5N).

14. Dispositif de plateau tournant selon l'une quelconque des revendications 1 à 13, **caractérisé par**

   - au moins deux premiers dispositifs de pompage (71 - 74), qui sont reliés en cas de rotation du carrousel transporteur de façon successive aux stations de traitement (51, 52, ..., 5N).

15. Dispositif de plateau tournant selon l'une quelconque des revendications 1 à 14, **caractérisé par**
un premier dispositif de pompage (74) pour l'évacuation du gaz de procédé.

16. Dispositif de plateau tournant selon l'une quelconque des revendications 1 à 15,
**caractérisé en ce que**
le premier dispositif de pompage (72, 74) présente au moins deux niveaux de pompage (721, 722, 741, 742) branchés les uns derrière les autres.

17. Dispositif de plateau tournant selon l'une quelconque des revendications précédentes, **caractérisé en ce que** le dispositif présente au moins deux dispositifs de pompage de même type ou équivalents.

18. Dispositif de plateau tournant selon la revendication 17,
**caractérisé par** un dispositif répartiteur (13, 15) pour la liaison des stations de traitement (51, 52, ..., 5N) avec les dispositifs de pompage (71 - 74), laquelle relie chaque fois l'un des dispositifs de pompage du même type ou équivalents à au moins une station de traitement pour la durée de phase de mise sous vide.

19. Dispositif de plateau tournant selon l'une quelconque des revendications précédentes, **caractérisé par**
un dispositif pour l'arrivée de gaz de procédé dans les stations de traitement (51, 52, ..., 5N).

20. Dispositif de plateau tournant selon l'une quelconque des revendications précédentes, **caractérisé par**
un dispositif pour l'arrivée d'énergie électromagnétique, de préférence de micro-ondes.

21. Procédé pour le revêtement CVD de pièces dans un dispositif de plateau tournant (1), en particulier selon l'une quelconque des revendications précédentes,

   - au moins une pièce étant introduite dans une station de traitement (51, 52, ..., 5N) sur un carrousel transporteur (3) rotatif,
   - la station de traitement (51, 52, ..., 5N) étant reliée par au moins un dispositif répartiteur (13, 15) à au moins un premier dispositif de pompage (71 - 74),
   - la station de traitement (51, 52, ..., 5N) étant mise sous vide, et
   - la pièce étant revêtue,

   le premier dispositif de pompage (71 - 74) étant transporté avec le carrousel transporteur (3),
   **caractérisé en ce que** le dispositif de pompage (71 - 74, 91 - 96) est relié uniquement à respectivement une station de traitement (51, 52, ..., 5N) au moyen du au moins dispositif répartiteur (13, 15) pour la liaison des stations de traitement (51, 52, ..., 5N) au premier dispositif de pompage (71 - 74) pendant la mise sous vide.

22. Procédé selon la revendication 21, **caractérisé en ce que**
la pièce est revêtue par l'arrivée de gaz de procédé et l'énergie électromagnétique dans la station de traitement (51, 52, ..., 5N).

23. Procédé selon l'une quelconque des revendications 21 ou 22, **caractérisé par** les étapes de la ventilation et de l'enlèvement de la pièce.

**24.** Procédé selon l'une quelconque des revendications 21 - 23 précédentes, la station de traitement (51, 52, ..., 5N) étant reliée à au moins un second dispositif de pompage (91 - 92) fixe.

**25.** Procédé selon la revendication 24, **caractérisé en ce que**

- les dispositifs de pompage (71 - 74, 91 - 96) sont reliés de façon successive aux stations de traitement (51, 52, ..., 5N).

**26.** Procédé selon la revendication 24 ou 25, **caractérisé en ce que** le second dispositif de pompage (93 - 96) est exploité comme étage préliminaire du premier dispositif de pompage (71 - 74).

**27.** Procédé selon l'une quelconque des revendications 21 à 26 précédentes,
**caractérisé en ce que**
du gaz de procédé est aspiré pendant le revêtement avec un premier dispositif de pompage (74).

**28.** Procédé selon l'une quelconque des revendications 21 à 27 précédentes,
**caractérisé en ce que**
deux ou plus de deux premiers dispositifs de pompage (71, 72, 73) sont branchés les uns derrière les autres au moins temporairement pendant la mise sous vide.

**29.** Procédé selon l'une quelconque des revendications 21 à 28 précédentes,
**caractérisé en ce que**
la liaison des stations de traitement (51, 52, ..., 5N) avec le premier (71, 72, 73) ou le second dispositif de pompage (91, 92) s'effectue par la commutation de vannes de commande (15).

**30.** Procédé selon l'une quelconque des revendications 21 à 29 précédentes,
**caractérisé en ce que**
la mise sous vide s'effectue en au moins deux étapes.

**31.** Procédé selon la revendication 31,
**caractérisé en ce que**
on commute entre les étapes entre différents dispositifs de pompage (71, 72, 73, 91, 92).

**32.** Procédé selon la revendication 32, comprenant quatre ou cinq étapes de mise sous vide.

**33.** Procédé selon la revendication 32, la pression dans une station de traitement étant réduite de façon progressive dans une première étape jusqu'à une valeur ≤ 200 mbar, dans une seconde étape consécutive jusqu'à une valeur ≤ 80 mbar, dans une troisième étape consécutive jusqu'à une valeur ≤ 1,5 mbar, dans une quatrième étape consécutive jusqu'à une valeur ≤ 0,1 mbar et, en cas de mise sous vide en cinq étapes, dans une cinquième étape consécutive jusqu'à une valeur ≤ 0,01 mbar.

**34.** Procédé selon l'une quelconque des revendications 21 à 33 précédentes, **caractérisé en ce que** la mise sous vide des stations de traitement s'effectue pendant au moins une phase de mise sous vide avec au moins deux dispositifs de pompage du même type ou équivalents.

**35.** Procédé selon la revendication 34, **caractérisé en ce qu'**à chaque fois l'un des dispositifs de pompage du même type ou équivalents est relié à au moins une station de traitement pour la durée de la au moins phase de mise sous vide.

**36.** Procédé selon l'une quelconque des revendications 21 à 35,
les pièces étant en forme de corps creux,
**caractérisé en ce que**
la pièce est revêtue par l'inflammation d'un plasma dans la zone intérieure des pièces.

Fig. 1A

Fig. 1B

## Fig. 2

EP 1 507 895 B1

Fig. 3

21

Fig. 4A

Fig. 4B

**IN DER BESCHREIBUNG AUFGEFÜHRTE DOKUMENTE**

**In der Beschreibung aufgeführte Patentdokumente**

- DE 19916478 A1

- WO 0058631 A